# EUROPÄISCHE PATENTSCHRIFT

(11) **EP 0 998 757 B1**
(45) Veröffentlichungstag und Bekanntmachung des Hinweises auf die Patenterteilung: **01.12.2004**
(21) Anmeldenummer: 98933506.2
(22) Anmeldetag: 11.05.1998
(51) Int. Cl.: H01L 23/485, H01L 21/768

(54) **INTEGRIERTE SCHALTUNGSANORDNUNG UND VERFAHREN ZU DEREN HERSTELLUNG**
INTEGRATED CIRCUIT AND METHOD FOR THE PRODUCTION THEREOF
CIRCUIT INTEGRE ET SON PROCEDE DE PRODUCTION

(30) Priorität: 18.07.1997 DE 19730974
(43) Veröffentlichungstag der Anmeldung: 10.05.2000
(73) Patentinhaber: Infineon Technologies AG, 81669 München (DE)
(72) Erfinder: SCHWALKE, Udo, D-84431 Heldenstein (DE); LUDWIG, Burkhard, D-81379 München (DE)
(74) Vertreter: Epping, Hermann, Fischer
(86) Internationale Anmeldenummer: PCT/DE1998/001312
(87) Internationale Veröffentlichungsnummer: WO 1999/004431

(56) Entgegenhaltungen:
- US-A- 4 945 067
- US-A- 5 441 915
- PATENT ABSTRACTS OF JAPAN vol. 097, no. 001, 31. Januar 1997 & JP 08 236767 A (MATSUSHITA ELECTRIC IND CO LTD), 13. September 1996 & US 5 698 902 A (TAKASHI UEHARA ET AL.) 16. Dezember 1997
- D. WIDMANN, H. MADER, H.FRIEDRICH: "Technologie hochintegrierter Schaltungen" SPRINGER VERLAG,1996, Seiten 346-347, XP002082112 in der Anmeldung erwähnt

## Beschreibung

Bei der Realisierung von integrierten Schaltungsanordnungen mit hoher Packungsdichte und insbesondere mit Strukturgrößen unter 0,25 µm gewinnt die Frage der Planarität zunehmend an Bedeutung. Bei der Herstellung der integrierten Schaltungsan ordnung werden auf einem Halbleitersubstrat Nutzstrukturen erzeugt, die eine schaltungstechnische Funktion in der Schal tungsanordnung haben. Derartige Nutzstrukturen sind zum Beispiel Anschlußelektroden, Gateelektroden oder Leitbahnen. Diese Nutzstrukturen sind jeweils in Ebenen durch Strukturie rung einer zuvor erzeugten Schicht hergestellt. Zwischen auf einanderfolgenden Ebenen sind Isolationsschichten vorgesehen Diese Isolationsschichten werden durch Polieren und/oder Ätzen planarisiert. Die JP-A-08 236 767 zeigt eine integrierte Schaltungsanordnung mit Nutzstrukturen.

Die erzielbare Planarität beim Planarisieren von Schichten hängt dabei von der geometrischen Dichte der Nutzstrukturen in der jeweiligen Ebene ab. Bei einer sehr ungleichmäßigen Belegung mit Nutzstrukturen ergeben sich lokal große Freiräume, in denen bei den Planarisierungsverfahren Unebenheiten auftreten. Daher ist vorgeschlagen worden (siehe zum Beispiel D. Widmann, H. Mader, H. Friedrich, Technologie hochintegrierter Schaltungen, 2. Auflage, Springer-Verlag, 1996, Seite 346 bis 347) zwischen den Nutzstrukturen Füllstrukturen einzufügen, die schaltungstechnisch ohne Funktion sind, die jedoch die lokale geometrische Dichte erhöhen. Dadurch wird eine gleichmäßige Belegung in der jeweiligen Ebene sichergestellt, die eine höhere Planarität nach Planarisierungsschritten ermöglicht.

Bestehen die Nutzstrukturen und die Füllstrukturen aus leitfähigem Material, so kann es im Betrieb zu einer Aufladung der Füllstrukturen kommen. Um diese zu vermeiden, werden die Füllstrukturen auf ein festes Potential gelegt, wie bei Widmann et al gezeigt. Diese Kontaktierung erfolgt über eine spezielle Verdrahtung, die in einer über den Nutz- und Füllstrukturen angeordneten Metallisierungsebenen angeordnet ist. Diese zusätzliche Verdrahtung und die Kontakte zwischen der zusätzlichen Verdrahtung und den Füllstrukturen erschwert die Erstellung des Layouts.

Der Erfindung liegt das Problem zugrunde, eine integrierte Schaltungsanordnung anzugeben, die mit hoher Planarität herstellbar ist, bei der eine Aufladung elektrisch leitender Füllstrukturen vermieden wird und für die das Layout mit verringertem Aufwand erstellbar ist. Ferner soll ein Verfahren zur Herstellung einer solchen Schaltungsanordnung angegeben werden.

Dieses Problem wird erfindungsgemäß gelöst durch eine integrierte Schaltungsanordnung gemäß Anspruch 1 sowie durch ein Verfahren zu deren Herstellung gemäß Anspruch 7. Weitere Ausgestaltungen der Erfindung gehen aus den übrigen Ansprüchen hervor.

In der integrierten Schaltungsanordnung ist in einem Halbleitersubstrat ein dotiertes Gebiet vorgesehen. An der Oberfläche des Halbleitersubstrats ist eine Ebene mit leitenden Nutzstrukturen und mindestens einer leitenden Füllstruktur angeordnet. Die leitenden Nutzstrukturen sind zum Beispiel Anschlußelektroden, Gateelektroden, Leiterbahnstücke, Verdrahtungen oder ähnliches. Die leitende Füllstruktur ist mit dem dotierten Gebiet leitend verbunden. Als dotiertes Gebiet ist zum Beispiel der Substratkörper selbst oder eine dotierte Wanne, in der aktive Bauelemente angeordnet sind, geeignet. Der Substratkörper und/oder die dotierte Wanne, in denen Bauelemente angeordnet sind, werden in integrierten Schaltungsanordnungen ohnehin beim Betrieb mit einer festen Versorgungsspannung beaufschlagt. Die Verbindung mit der leitenden Füllstruktur stellt sicher, daß auch die leitende Füllstruktur auf diesem Potential liegt. Da die dotierte Wanne oder der Substratkörper ohnehin mit festem Potential verbunden sind, kann somit in der erfindungsgemäßen integrierten Schaltungsanordnung die zusätzliche Verdrahtung, die nur zu dem Zweck des Anschlusses der Füllstrukturen vorgesehen wird, entfallen. Damit vereinfacht sich das Layout. Es kann insbesondere durch automatische Layoutgenerierung erstellt werden. Die Lage der Füllstruktur ist programmgesteuert bestimmbar.

Vorzugsweise erfolgt die elektrische Verbindung der leitenden Füllstruktur mit dem dotierten Gebiet über ein Kontaktloch und einen Kontakt. Das Kontaktloch überlappt die leitende Füllstruktur und das dotierte Gebiet, so daß die Oberfläche der leitenden Füllstruktur und des dotierten Gebietes mit dem Kontakt in Verbindung stehen. Das Kontaktloch und der Kontakt werden vorzugsweise gleichzeitig mit Kontaktlöchern und Kontakten zu leitenden Nutzstrukturen hergestellt. Es sind daher keine zusätzlichen Prozeßschritte dafür erforderlich.

Da nur sehr geringe Ströme (Aufladungen, kapazitive Verschiebeströme etc.) abgeführt werden müssen, ist ein überlappender Kontakt nicht zwingend notwendig. Im Prinzip genügt auch schon die Seitenwandkontaktfläche. Auch andere, hochohmige Ableitungen über Bauelemente sind hierzu geeignet.

Zur Verbindung zwischen der leitenden Füllstruktur und dem dotierten Gebiet über ein Bauelement sind als Bauelemente zum Beispiel ein MOS-Transistor (vollständig oder teilweise eingeschaltet), zwei gegenpolig geschaltete Dioden oder ähnliches geeignet. Sie werden beispielsweise dadurch realisiert, daß die Füllstruktur über das Isolationsgebiet hinausgeführt wird und mittels Kontakt mit der Nutzstruktur, zum Beispiel einer Junction, verbunden wird.

Es liegt im Rahmen der Erfindung, oberhalb der Ebene, in der die leitende Füllstruktur angeordnet ist, eine Metallisierungsebene anzuordnen und die leitende Füllstruktur über einen weiteren Kontakt mit der Metallisierungsebene zu verbinden. Diese Anordnung ist vorteilhaft, wenn die Metallisierungsebene, mit der die Füllstruktur über den weiteren Kontakt verbunden ist, im Betrieb auf demselben Potential wie das dotierte Gebiet liegt. Der Kontakt und der weitere Kontakt bilden in diesem Fall einen zusätzlichen integrierten Kontakt für das dotierte Gebiet.

Die Ebene, in der die leitende Füllstruktur angeordnet ist, kann sowohl eine Gateebene sein, die in der Nähe der Oberfläche des Halbleitersubstrats angeordnet ist, als auch eine Metallisierungsebene, die oberhalb der Gateebene und/oder weiterer Metallisierungsebenen angeordnet ist.

Zur Herstellung der integrierten Schaltungsanordnung wird in dem Halbleitersubstrat ein dotiertes Gebiet gebildet. Auf dem Halbleitersubstrat wird durch Aufbringen und Strukturieren einer leitfähigen Schicht die Ebene mit leitenden Nutzstrukturen und mindestens einer leitenden Füllstruktur gebildet. Es wird eine Isolationsstruktur erzeugt, die die leitenden Nutzstrukturen und die leitende Füllstruktur umgibt und bedeckt. Da die leitenden Nutzstrukturen und die leitende Füllstruktur aus der leitfähigen Schicht gebildet werden, weisen sie im wesentlichen die gleiche Höhe auf. Vorzugsweise wird die Verbindung zwischen dem dotierten Gebiet und der leitenden Füllstruktur durch Öffnen eines Kontaktloches, das die leitende Füllstruktur und das dotierte Gebiet überlappt, und Bildung eines Kontaktes erzeugt.

Es liegt im Rahmen der Erfindung, als Halbleitersubstrat eine monokristalline Siliziumscheibe, die monokristalline Siliziumschicht eines SOI-Substrates mit einer Trägerscheibe, einer isolierenden Schicht und einer monokristallinen Siliziumschicht oder ein Substrat, das SiC enthält, zu verwenden.

Die Verbindung der leitenden Füllstruktur mit dem dotierten Gebiet kann alternativ über eine lokale Verdrahtungsebene vorgenommen werden. Als lokale Verdrahtungsebene wird eine in der lateralen Umgebung wirksame, elektrisch leitende Verbindung bezeichnet. Lokale Verdrahtungsebenen werden zum Beispiel aus TiSi₂ in Form von streifenförmigen Leitern, sogenannten TiSi₂-Strap, gebildet.

Für den Fall, daß die Ebene, in der die leitende Füllstruktur angeordnet ist, die Gateebene ist, enthalten die leitenden Nutzstrukturen Gateelektroden. Die Gateelektroden können sowohl durch Strukturierung einer leitfähigen Schicht, aus der dann auch die leitende Füllstruktur gebildet wird, als auch durch Strukturierung mehrerer Teilschichten gebildet werden.

Es liegt im Rahmen der Erfindung, daß derjenige Teil des dotierten Gebietes, der von dem Kontaktloch zur Verbindung mit der leitenden Füllstruktur überlappt wird, von Teilen des dotierten Gebietes, in denen aktive Elemente der Schaltungsanordnung angeordnet sind, durch eine Isolationsstruktur, zum Beispiel einen mit isolierendem Material gefüllten Graben, getrennt sind. Das dotierte Gebiet reicht in diesem Fall tiefer in das Substrat hinein als die Isolationsstruktur. Dadurch werden Kurzschlüsse zwischen aktiven Elementen und dem Kontakt vermieden.

Im folgenden wird die Erfindung anhand eines Ausführungsbeispiels, das in den Figuren dargestellt ist, näher erläutert.
- Figur 1: zeigt einen Schnitt durch ein Halbleitersubstrat mit Isolationsbereichen und einer dotierten Wanne.
- Figur 2: zeigt den Schnitt durch das Halbleitersubstrat nach Bildung eines Gateoxids und Abscheidung einer leitfähigen Schicht.
- Figur 3: zeigt den Schnitt durch das Halbleitersubstrat nach Strukturierung der leitfähigen Schicht zur Bildung von leitenden Nutzstrukturen und leitenden Füllstrukturen und nach Bildung von Source-/Drain-Gebieten und einem Wannenkontakt.
- Figur 4: zeigt den Schnitt durch das Halbleitersubstrat nach Bildung einer planarisierenden Isolationsschicht.
- Figur 5: zeigt den Schnitt durch das Halbleitersubstrat nach Bildung einer Zwischenoxidschicht.
- Figur 6: zeigt den Schnitt durch das Halbleitersubstrat nach Bildung von Kontaktlöchern und Kontakten.
- Figur 7: zeigt den Schnitt durch das Halbleitersubstrat nach Bildung einer Metallisierungsebene und einem weiteren Kontakt zwischen der leitenden Füllstruktur und der Metallisierungsebene.

Die Darstellungen in den Figuren sind nicht maßstäblich.

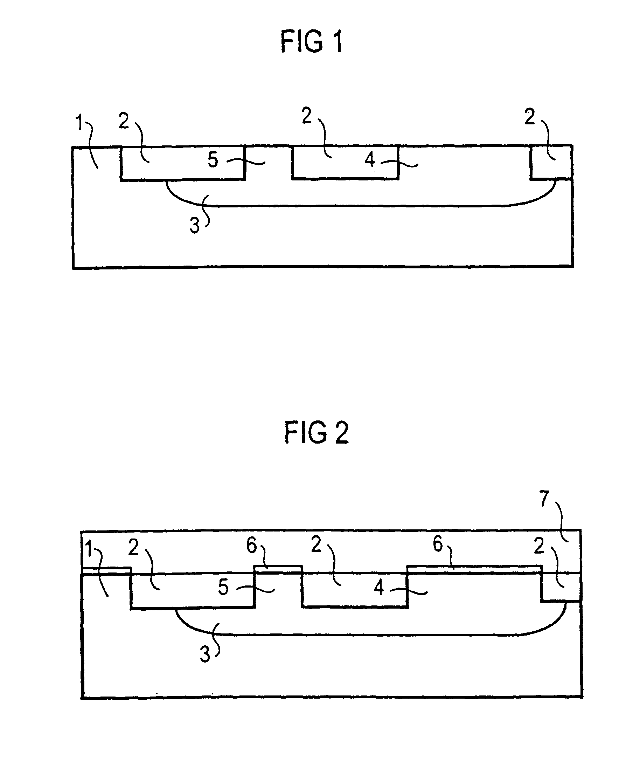

In der Oberfläche eines Substrats 1 aus monokristallinem Silizium werden durch Ätzen von Gräben und Auffüllen der Gräben mit isolierendem Material Isolationsgräben 2 gebildet (siehe Figur 1). Das Auffüllen der Isolationsgräben 2 erfolgt durch planarisierende Schritte, zum Beispiel durch chemisch-mechanisches Polieren. Anschließend wird unter Verwendung photolithographischer Prozeßschritte eine maskierte Ionenimplantation durchgeführt zur Bildung einer p-dotierten Wanne 3. Die dotierte Wanne 3 ist zum Beispiel mit Bor und einer Dotierstoffkonzentration von 5 x10¹⁷ at/cm³ dotiert.

Die dotierte Wanne 3 weist eine größere Tiefe als die Isolationsgräben 2 auf. Die dotierte Wanne 3 wird seitlich von einem der Isolationsgräben 2 umgeben. Ein weiterer Isolationsgraben 2 ist innerhalb der dotierten Wanne 3 so angeordnet, daß die dotierte Wanne 3 in einem aktiven Gebiet 4 und in einem Anschlußgebiet 5 an die Oberfläche des Substrats 1 angrenzt. Das aktive Gebiet 4 ist zur Aufnahme aktiver Elemente vorgesehen.

Die Tiefe der dotierten Wanne 3 beträgt zum Beispiel 1 µm. Die Tiefe der Isolationsgräben 2 beträgt zum Beispiel 400 nm.

Anschließend wird zum Beispiel durch thermische Oxidation ein Gateoxid 6 gebildet (siehe Figur 2). Das Gateoxid 6 wird zum Beispiel in einer Schichtdicke von 6 nm gebildet. Anschließend wird eine leitfähige Schicht 7 abgeschieden. Für die leitfähige Schicht 7 ist jedes Material geeignet, das zur Bildung von Gateelektroden geeignet ist, insbesondere dotiertes Polysilizium, Metallsilizid, TiN. Die leitfähige Schicht 7 wird in einer Schichtdicke von zum Beispiel 200 nm gebildet.

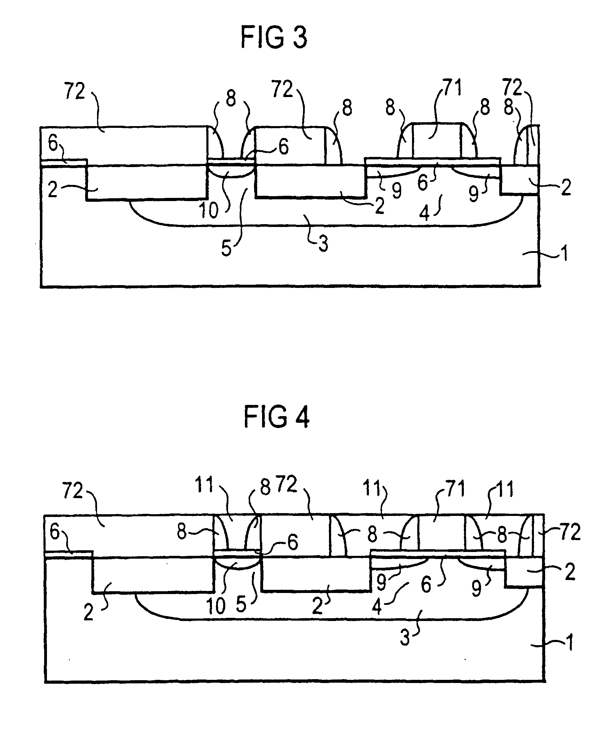

Unter Verwendung photolithographischer Prozeßschritte wird die leitfähige Schicht 7 so strukturiert, daß daraus leitfähige Nutzstrukturen 71 und leitende Füllstrukturen 72 gebildet werden (siehe Figur 3). Die leitenden Nutzstrukturen 71 sind zum Beispiel Gateelektroden. Die leitenden Füllstrukturen 72 sind schaltungstechnisch ohne Funktion. Sie werden so angeordnet, daß eine gleichmäßige geometrische Belegung durch die leitenden Nutzstrukturen und die leitenden Füllstrukturen gegeben ist.

Durch konforme Abscheidung und anisotropes Rückätzen einer SiO₂-Schicht werden an den Flanken der leitenden Nutzstruktur 71 und der leitenden Füllstruktur 72 SiO₂-Spacer 8 gebildet.

Durch maskierte Ionenimplantation, bei der die Oberfläche des aktiven Gebietes 4 freiliegt, die Oberfläche des Anschlußgebietes 5 jedoch abgedeckt ist, werden Source-/Drain-Gebiete 9 selbstjustiert zu der leitenden Nutzstruktur 71 gebildet. Die Source-/Drain-Gebiete 9 sind zum Beispiel mit Arsen oder Phosphor dotiert und weisen eine Dotierstoffkonzentration von 8 x 10¹⁹ at/cm³ auf.

Anschließend wird unter Verwendung einer weiteren Maske, die das aktive Gebiet 4 abdeckt, das Anschlußgebiet 5 jedoch unbedeckt läßt, ein Wannenkontakt 10 gebildet. Der Wannenkontakt 10 wird zum Beispiel mit Bor dotiert und weist eine Dotierstoffkonzentration von 6 x 10¹⁹ at/cm³ auf.

Anschließend wird eine planarisierende Isolationsschicht 11 gebildet, die durch chemisch-mechanisches Polieren soweit zurückgeschliffen wird, daß sie in der Höhe mit der leitenden Nutzstruktur 71 und den leitenden Füllstrukturen 72 abschließt (siehe Figur 4). Beim Planarisieren der planarisierenden Isolationsschicht 11 wirken die leitende Nutzstruktur 71 und die leitenden Füllstrukturen 72 als Planarisierungsstützstellen.

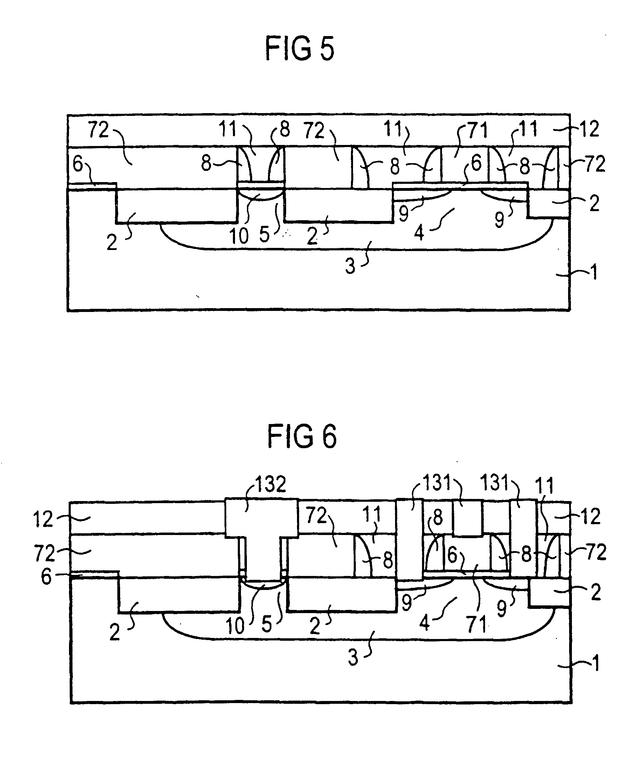

Anschließend wird eine erste Zwischenoxidschicht 12 abgeschieden. Mit Hilfe photolithographischer Prozeßschritte und anisotropem Trockenätzen werden Kontaktlöcher zu den Source-/Drain-Gebieten 9, zu der leitenden Nutzstruktur 71 und zu dem Wannenkontakt 10 und den benachbarten leitenden Füllstrukturen 72 geätzt (siehe Figur 6). Durch Auffüllen der Kontaktlöcher mit Metall, zum Beispiel Wolfram, werden Kontakte 131 zu den Source-/Drain-Gebieten 9 und der leitenden Nutzstruktur 71 und ein überlappender Kontakt 132 zu dem Wannenkontakt 10 und den benachbarten leitenden Füllstrukturen 72 gebildet (siehe Figur 6). Der überlappende Kontakt 132 steht sowohl mit der Oberfläche der benachbarten leitenden Füllstrukturen 72 als auch mit der Oberfläche des Wannenkontaktes in Verbindung. Dadurch werden die Füllstrukturen 72 über den Wannenkontakt 10 mit der dotierten Wanne 3 verbunden.

Alternativ wird der überlappende Kontakt 132 so angeordnet, daß er auf die Oberfläche des Substrats 1 trifft. In diesem Fall wird ein Substratkontakt an der Oberfläche des Substrats 1 durch Implantation mit Dotierstoff, das denselben Leitfähigkeitstyp wie das Substrat aufweist bewirkt, gebildet.

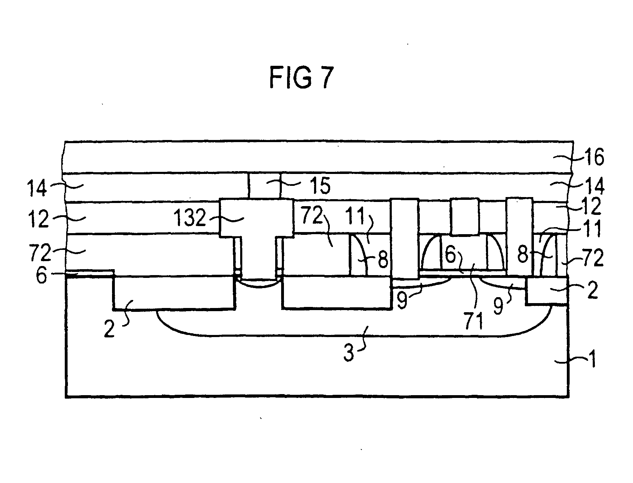

Nachfolgend wird eine zweite Zwischenoxidschicht 14 abgeschieden, in der ein weiteres Kontaktloch, das auf den überlappenden Kontakt 132 trifft, geöffnet wird. Das weitere Kontaktloch wird mit einem weiteren Kontakt 15 zum Beispiel aus Wolfram aufgefüllt. Schließlich wird eine Metallisierungsebene 16 gebildet, die mit dem weiteren Kontakt 15 in Verbindung steht (siehe Figur 7). Die Metallisierungsebene 16 wird im Betrieb der Schaltungsanordnung auf das gleiche Potential wie die dotierte Wanne 3 gelegt.

## Patentansprüche

1. Integrierte Schaltungsanordnung,
- bei der in einem Halbleitersubstrat (1) mindestens ein dotiertes Gebiet (3) vorgesehen ist,
- bei der an der Oberfläche des Halbleitersubstrats (1) eine Ebene mit leitenden Nutzstrukturen (71) und mindestens einer leitenden Füllstruktur (72), die schaltungstechnisch ohne Funktion ist und im wesentlichen die gleiche Höhe wie die Nutzstrukturen (71) aufweist, angeordnet ist,
- bei oder die leitenden Nutzstrukturen (71) und die leitende Füllstruktur (72) von einer planarisierenden Isolationsschicht (11 , 12) umgehen sind, wobei, die leitende Füllstruktur (72) mit dem dotierten Gebiet (3) leitend verbunden ist.

2. Schaltungsanordnung nach Anspruch 1 ,
bei der die leitende Füllstruktur (72) über ein Kontaktloch und einen Kontakt (132) mit dem dotierten Gebiet verbunden ist.

3. Schaltungsanordnung nach Anspruch 2,
bei der das Kontaktloch die leitende Füllstruktur (72) und das dotierte Gebiet (3) überlappt, so daß die Oberfläche der leitenden Füllstruktur (72) und des dotierten Gebietes (3) mit dem Kontakt (132) in Verbindung stehen.

4. Schaltungsanordnung nach einem der Ansprüche 1 bis 3,
bei der die leitenden Nutzstrukturen (71) Gateelektroden sind und bei dem die leitende Füllstruktur (72) das Material der Gateelektrode enthält.

5. Schaltungsanordnung nach einem der Ansprüche 1 bis 4,
bei der das dotierte Gebiet (3) eine dotierte Wanne oder das Halbleitersubstrat ist.

6. Schaltungsanordnung nach einem der Ansprüche 1 bis 5,
- bei dem oberhalb der Ebene, in der die leitende Füllstruktur (72) angeordnet ist, eine Metallisierungsebene (16) angeordnet ist,
- bei dem die leitende Füllstruktur (72) über einen weiteren Kontakt (15) mit der Metallisierungsebene (16) verbunden ist.

7. Verfahren zur Herstellung einer integrierten Schaltungsanordnung,
- bei dem in einem Halbleitersubstrat (1) ein dotiertes Gebiet (3) gebildet wird,
- bei dem auf das Halbleitersubstrat (1) eine leitfähige Schicht (7) aufgebracht wird und durch Strukturieren der aufgebrachten leitfähigen Schicht (7) leitende Nutzstrukturen (71) und mindestens eine leitende Füllstruktur (72), welche schaltungstechnisch ohne Funktion ist und im wesentlichen die gleiche Höhe wie die Nutzstrukturen (71) aufweist, gebildet werden, und
- bei dem eine Isolationsschicht (11, 12) erzeugt wird, die die leitenden Nutzstrukturen (71) und die leitende Füllstruktur (72) umgibt und bedeckt, wobei
eine leitende Verbindung zwischen der leitenden Füllstruktur (72) und dem dotierten Gebiet (3) erzeugt wird.

8. Verfahren nach Anspruch 7,
- bei dem in der Isolationsschicht (11, 12) ein Kontaktloch geöffnet wird, das die leitende Füllstruktur (72) und das dotierte Gebiet (3) jeweils teilweise überlappt, so daß die Oberfläche des dotierten Gebietes (3) und der leitenden Füllstruktur (72) teilweise freigelegt wird,
- bei dem in dem Kontaktloch ein Kontakt (132) gebildet wird, der mit der Oberfläche der leitenden Füllstruktur (72) und des dotierten Gebietes (3) in Verbindung steht.

9. Verfahren nach Anspruch 7 oder 8,
- bei dem oberhalb der Ebene, in der die leitende Füllstruktur (72) angeordnet ist, eine Metallisierungsebene (16) erzeugt wird,
- bei dem ein weiterer Kontakt (15) erzeugt wird, über den die leitende Füllstruktur mit der Metallisierungsebene (16) verbunden wird.

## Claims

1. Integrated circuit arrangement
- in which at least one doped region (3) is provided in a semiconductor substrate (1),
- in which a plane having conductive useful structures (71) and at least one conductive filling structure (72), which has no circuitry function and essentially has the same height as the useful structures (71), is arranged on the surface of the semiconductor substrate (1),
- in which the conductive useful structures (71) and the conductive filling structure (72) are surrounded by a planarizing insulation layer (11, 12),
the conductive filling structure (72) being conductively connected to the doped region (3).

2. Circuit arrangement according to Claim 1,
in which the conductive filling structure (72) is connected to the doped region via a contact hole and a contact (132).

3. Circuit arrangement according to Claim 2,
in which the contact hole overlaps the conductive filling structure (72) and the doped region (3), with the result that the surface of the conductive filling structure (72) and of the doped region (3) are connected to the contact (132).

4. Circuit arrangement according to one of Claims 1 to 3,
in which the conductive useful structures (71) are gate electrodes and in which the conductive filling structure (72) contains the material of the gate electrode.

5. Circuit arrangement according to one of Claims 1 to 4,
in which the doped region (3) is a doped well or the semiconductor substrate.

6. Circuit arrangement according to one of Claims 1 to 5,
- in which a metallization plane (16) is arranged above the plane in which the conductive filling structure (72) is arranged,
- in which the conductive filling structure (72) is connected to the metallization plane (16) via a further contact (15).

7. Method for the production of an integrated circuit arrangement,
- in which a doped region (3) is formed in a semiconductor substrate (1),
- in which a conductive layer (7) is applied to the semiconductor substrate (1) and by patterning the applied conductive layer (7) conductive useful structures (71) and at least one conductive filling structure (72), which has no circuitry function and essentially has the same height as the useful structures (71), are formed, and
- in which an insulation layer (11, 12) is fabricated which surrounds and covers the conductive useful structures (71) and the conductive filling structure (72),
a conductive connection being fabricated between the conductive filling structure (72) and the doped region (3).

8. Method according to Claim 7,
- in which a contact hole is opened in the insulation layer (11, 12), which contact hole in each case partially overlaps the conductive filling structure (72) and the doped region (3), with the result that the surface of the doped region (3) and of the conductive filling structure (72) is partially uncovered,
- in which a contact (132) is formed in the contact hole, which contact is connected to the surface of the conductive filling structure (72) and of the doped region (3).

9. Method according to Claim 7 or 8,
- in which a metallization plane (16) is fabricated above the plane in which the conductive filling structure (72) is arranged,
- in which a further contact (15) is fabricated via which the conductive filling structure is connected to the metallization plane (16).

## Revendications

1. Circuit intégré
- dans lequel il est prévu dans un substrat (1) semi-conducteur au moins une zone (3) dopée,
- dans lequel il est disposé à la surface du substrat (1) semi-conducteur un plan ayant des structures (71) utiles conductrices et au moins une structure (72) de remplissage conductrice qui est sans fonction du point de vue de la technique du circuit et qui a sensiblement le même niveau que les structures (71 ) utiles,
- dans lequel les structures (71) utiles conductrices et la structure (72) de remplissage conductrice sont entourées d'une couche (11, 12) isolante de planarisation, la structure (72) de remplissage conductrice étant reliée de manière conductrice à la zone (3) dopée.

2. Circuit intégré suivant la revendication 1, dans lequel la structure (72) de remplissage conductrice est reliée à la zone dopée par un trou de contact et par un contact (132).

3. Circuit intégré suivant la revendication 2, dans lequel le trou de contact chevauche la structure (72) de remplissage conductrice et la zone (3) dopée, de sorte que les surfaces de la structure (72) de remplissage conductrice et de la zone (3) dopée sont en liaison avec le contact (132).

4. Circuit intégré suivant l'une des revendications 1 à 3, dans lequel les structures (71) utiles conductrices sont des électrodes de grille et dans lequel la structure (72) de remplissage conductrice contient le matériau des électrodes de grille.

5. Circuit intégré suivant l'une des revendications 1 à 4, dans lequel la zone (3) dopée est une cuvette dopée ou le substrat semi-conducteur.

6. Circuit intégré suivant l'une des revendications 1 à 5
- dans lequel au-dessus du plan dans lequel se trouve la structure (72) de remplissage conductrice est disposé un plan (16) de métallisation,
- dans lequel la structure (72) de remplissage conductrice est reliée au plan (16) de métallisation par un autre contact (15).

7. Procédé de production d'un circuit intégré
- dans lequel on forme dans un substrat (1) semi-conducteur une zone (3) dopée,
- dans lequel on dépose sur le substrat (1) semi-conducteur une couche (7) conductrice et, par structuration de la couche (7) conductrice déposée, on forme des structures (71) utiles conductrices et au moins une structure (72) de remplissage conductrice qui est sans fonction du point de vue de la technique des circuits et qui a sensiblement le même niveau que les structures (71 ) utiles, et
- dans lequel on produit une couche (11, 12) d'isolement qui entoure et recouvre les structures (71) utiles conductrices et la structure (72) de remplissage conductrice, dans lequel
on produit une liaison conductrice entre la structure (72) de remplissage conductrice et la zone (3) dopée.

8. Procédé suivant la revendication 7
- dans lequel on ouvre dans la couche (11, 12) isolante un trou de contact, qui chevauche au moins en partie la structure (72) de remplissage conductrice et la zone (3) dopée de façon à mettre à nu au moins en partie les surfaces de la zone (3) dopée et de la structure (72) de remplissage conductrice,
- dans lequel on forme dans le trou de contact un contact (132) qui est en liaison avec les surfaces de la structure (72) de remplissage conductrice et de la zone (3) dopée.

9. Procédé selon la revendication 7 ou 8
- dans lequel on produit au-dessus du plan dans lequel se trouve la structure (72) de remplissage conductrice un plan (16) de métallisation,
- dans lequel on produit un autre contact (15) par lequel la structure de remplissage conductrice est reliée au plan (16) de métallisation.
